# EUROPEAN PATENT SPECIFICATION

(11) **EP 2 445 847 B1**
(45) Date of publication and mention of the grant of the patent: **31.08.2016**
(21) Application number: 10791685.0
(22) Date of filing: 24.06.2010
(51) Int. Cl.: H01L 39/12, C04B 35/462, C01G 45/00

(54) **HIGH TEMPERATURE SUPERCONDUCTOR**
HOCHTEMPERATUR-SUPRALEITER
SUPRACONDUCTEUR À HAUTE TEMPÉRATURE

(30) Priority: 24.06.2009 FI 20095711
(43) Date of publication of application: 02.05.2012
(73) Proprietor: Frantti, Johannes, 00180 Helsinki (FI); Fujioka, Yukari, 00180 Helsinki (FI)
(72) Inventor: Frantti, Johannes, 00180 Helsinki (FI); Fujioka, Yukari, 00180 Helsinki (FI)
(74) Representative: Papula Oy
(86) International application number: PCT/FI2010/050544
(87) International publication number: WO 2010/149860

(56) References cited:
- JP-A- 1 096 056
- FISK Z ET AL: "The new generation high-temperature superconductors", ANNUAL REVIEW OF MATERIALS SCIENCE, vol. 27, 1997, pages 35-67, XP055068711, ISSN: 0084-6600, DOI: 10.1146/annurev.matsci.27.1.35
- BECK E. ET AL: 'Investigation of superconductivity and physical properties of some spinel-, perovskite-, and pyrochlore-type oxides' J. LESS-COMMON METALS vol. 147, 1989, pages L17 - L20, XP024068513
- TOYOSAKI H. ET AL: 'Atomically smooth and single crystalline MnTi03 thin films with a ferrotoroidic structure' APPL. PHYS. LETT. vol. 93, no. 7, 2008, pages 072507 - 1 - 072507-3, XP012113558

## Description

### FIELD OF THE INVENTION

The present invention relates to superconductors having a layered structure. More specifically, it relates to high temperature superconductors (HTSCs) and materials used in HTSCs.

### BACKGROUND OF THE INVENTION

Superconductor is an element or a compound, which ideally displays superconducting properties - perfect electrical conductivity and perfect diamagnetism - only after cooling to very low temperatures of liquid helium. The transition temperature *T_{c},* below which a material begins to behave as a superconductor, is material-specific. High temperature superconductors are of great interest due to their obvious benefit over conventional superconductors. The best known HTSC materials have transition temperatures near or above the temperature of liquid nitrogen, which enables the use of liquid nitrogen instead of more expensive liquid helium for cooling of the materials.

One typical application of HTSCs is a Superconducting Quantum Interference device (SQUID), which can detect very weak magnetic fields, and is already used in medical applications, such as Magnetic Resonance Imaging (MRI). In addition, superconducting magnets featured in nuclear magnetic resonance (NMR) devices benefit from the utilization of HTSCs, which eliminates ohmic heating of magnets. Magnetic Levitated Car (MagLev) is the next-generation system of transportation, which uses magnetic levitation from a very large number of magnets for lift and propulsion. Use of HTSC magnets, cooled with inexpensive liquid nitrogen, makes the device to consume less energy than the non-superconducting magnets and thus be cost effective. Zero-energy loss power lines utilizing HTSCs to transmit electricity are also under development by e.g. Hitachi Cables and Sumitomo Electric.

At present, only a few crystal structures exist among HTSCs, some of them being based on the perovskite structures. Due to the complex crystal structure of the known HTSC materials such as YBa₂Cu₃O₇ and Bi₂Sr₂CaCu₂O₈, comprising usually at least four, often exotic, components, the known HTSCs are rather complicated and expensive to manufacture. The high fabrication costs reduce the use of HTSCs in industrial applications, e.g. thin films. Complexity of the HTSC structures itself makes also the manufacturing of the entire applications utilising them, e.g. high quality films, difficult. In addition, some of the elements used in the present HTSCs, like Hg, Tl and As, are harmful and toxic, which often restricts their commercial use. Utilization of the toxic elements is restricted for instance by the Restriction of Hazardous Substances (RoHS) directive adopted in 2003 by the European Union.

It is well-known that transition temperature of superconductors is correlated by the amount of oxygen in the crystal structure of the superconductor. One example is a widely studied HTSC YBa₂Cu₃O_{7-δ} (YBCO). The transition temperature *T_{c}* of said material depends on the oxygen content, i.e. parameter δ. The structure is given in terms of the orthorhombic unit cell dimensions (a = 3.83 Å, b = 3.88 Å, c = 11.68 Å) and is listed in Table 1. When δ = 1, the O(1) sites in the Cu(1) layer are vacant and the structure is tetragonal. The tetragonal form of YBCO is insulating and does not display superconductive properties. Increasing the oxygen content causes more of the O(1) sites to become occupied. Optimum superconducting properties occur when δ ~ 0.07 and all of the O(1) sites are occupied with few vacancies. Therefore, modification of the oxygen content of the material is crucial for YBa₂Cu₃O_{7-δ} to display superconductive properties, especially near or above the temperature of liquid nitrogen.

**Table 1.**

| Atom | *x* | *y* | z |
|---|---|---|---|
| Y | 1/2 | 1/2 | 1/2 |
| Ba | 1/2 | 1/2 | 0.1854 |
| Cu(1) | 0 | 0 | 0 |
| Cu (2) | 0 | 0 | 0.3555 |
| O(1) | 0 | 1/2 | 0 |
| O(2) | 1/2 | 0 | 0.3790 |
| O(3) | 0 | 1/2 | 0.3781 |
| O(4) | 0 | 0 | 0.1568 |

### PURPOSE OF THE INVENTION

The purpose of the present invention is to facilitate exploiting of superconductors by providing a novel group of simple structured superconductors, which can also act as high temperature superconductors.

### SUMMARY OF THE INVENTION

The superconductor according to the present invention is characterized by what is disclosed in claim 1. The use of a material according to the present invention is characterized by what is disclosed in claim 5.

The present invention is focused on a superconductor and use of a material in superconductor. As well known for those skilled in the art, superconductor means a material showing, below a so called critical temperature *T_{c}*, also called as transition temperature, almost perfect electrical conductivity and almost perfect diamagnetism. Almost perfect conductivity means that due to the thermal motion of the magnetic flux lines which decreases continuously with decreasing temperature, the electrical resistivity of superconductors does not necessarily go to zero. Almost perfect diamagnetism takes into account the fact that in superconductors external field can partially penetrated into the material in a form of magnetic flux lines. To which extent this occurs depends on the temperature, external magnetic field and material and results in the fact that diamagnetism is not perfect. By high temperature superconductors HTSCs is meant here superconductors having a critical temperature at or over about 25 K.

The superconductor of the present invention comprises material comprising alternately stacked first and second layers, each of the layers comprising a network of cations surrounded by anions. A layered crystal structure is a common feature with the known superconductors and HTSC materials like YBa₂Cu₃O₇ and Bi₂Sr₂CaCu₂O₈ and recently discovered LaO_{1-y}F_{y}FeAs. However, as an essential difference, according to the present invention, the superconductor comprises material having an ilmenite crystal structure and a general composition of type ABX₃, where A and B are elements dominantly occupying the cation sites of the first and the second layers, correspondingly, at least one of the elements A and B being a transition metal, and X is anion element and/or a negatively charged molecule dominantly occupying the anion sites.

In order to be organized as said ilmenite type crystal structure, the cation sites have to be occupied by elements having ionic radii roughly of a same size and occupy octahedral sites. Therefore, preferably, the composition weighted average of the cations' ionic radius is below 1 Å**.** Here, cations are the atoms occupying the cation sites of the material, and the composition weighted average is calculated separately for the elements dominantly occupying the cation sites A (A-cations) and B (B-cations). This is since the average A-cation radius should be comparable to the average B-cation radius. The composition weighted average ionic radius of the A-cations is calculated by multiplying the fraction of each cation element by the ionic radius of the element and summing the products over all cation types occurring at the A-site, and the composition weighted average cation radius of the B-cations is calculated in the same way.

Thus, if the A-cation site of an ilmenite compound is occupied by 40% of cations with an ionic radius of 0.80 Å and by 60% of cations with an ionic radius of 0.70 Å, the composition weighted average A-site cation radius is 0.74 Å. If the same compound has 50% of the B-site occupied by cations with an ionic radius of 0.70 Å and 25% with an ionic radius of 0.76 Å and 25% with an ionic radius of 0.64 Å, the composition weighted average B-site cation radius is 0.74 Å. In this example, the average A-cation radius is close to the average B-cation radius.

If the average size of the either or both A and B elements occupying cation cites becomes large, the crystal structure is changed. One example is the perovskite structure also having an ABX₃ stoichiometry. In general, a material organizes in perovskite structure if the A cation requires much longer bond lengths and a higher coordination number than the B cation element. This is demonstrated by BaTiO₃, which possesses the perovskite structure.

By ilmenite crystal structure is meant, firstly, the structure named after the mineral ilmenite FeTiO₃, the space group symmetry of the structure being R-3. However, here ilmenite is used as a more common definition covering also the closely related corundum crystal structure named after corundum Al₂O₃ with a space group symmetry R-3c. Actually, corundum can be considered as a special case of the more general definition of ilmenite. And as is known for a person skilled in the art, these two crystal structures are often classified as a single ilmenite-corundum structure. In fact, these two slightly different crystal structures can not even be distinguished by conventional crystal structure determination techniques based on x-ray diffraction. It is a common and convenient practice to specify the ilmenite structure in terms of hexagonal axes, which is a convention adopted here.

Both ilmenite and corundum structures comprise alternating first and second cation element - anion element layers, each consisting of blocks of cation element (M) - anion element (O) octahedra MO₆, stacked along the hexagonal c crystal axis. Cation elements A and B are typically metals and anion element is typically oxygen. Moreover, the definition ilmenite is meant here to cover also cases where at least one of the A and B cation sites are statistically occupied by at least two different elements. In this kind of material, the crystal symmetry can be slightly modified in comparison with that of the parent materials of said different elements.

By general composition and dominant occupation is meant that the stoichiometry of the material can deviate, to some extent, from said ABX₃. For example, not all cation or anion sites may be occupied, but there may be an empty site, called a vacancy site, or multiple empty cites, vacancies. This corresponds to a change in stoichiometry. Particularly, the content of anion, dominantly occupying the anion sites, is preferably decreased or increased from the accurate ratio 3:1:1 between the anion and the cation elements. As already stated above, also the cation sites can be partially occupied by some other element(s) and/or molecule(s) than A and B. In other words, said dominant occupation is a statistical expression meaning a clear majority, but not necessarily all, of said sites being occupied by said elements. As one specific variation of the general composition ABX₃, the cation elements A and B of the two layer types can also be the same material as in the corundum crystal structure with a general composition of a type A₂X₃. By properly selecting the accurate composition of the material, the superconducting and other properties of it can be adjusted.

A special case of the ilmenite structure is the so called lithium niobate structure, named after LiNbO₃. In the lithium niobate structure the octahedral sites occupied are the same ones as in the ilmenite. However, instead of the segregation of the A and B cations into alternate layers each layer in the lithium niobate structure contains both species in equal proportions. The characteristic feature that no cation is bridged through two oxygens to another like cation

A material according to the present invention, fulfilling the basic conditions concerning the material composition and structure, do not necessarily possess superconducting properties straight after the basic manufacturing process. It is, however, well-known for a man skilled in the art that to switch a non-superconducting ionic oxide material to a superconducting material, the number of electrons per a primitive cell shall be modified so that said number shall not be integer. This can be achieved by substituting cations or anions of the non-superconducting material with other elements, molecules or vacancies. This procedure is known as doping, and elements, molecules or vacancies added to the non-superconducting material are known as dopants. The dopant can also occupy an interstitial site in the non-superconducting material, or even be movable, which often is the case when dopants are hydrogen or lithium atoms. If the cation or anion is replaced by an element donating electrons to the compound (more precisely, to the conduction band), it is called an electron donor. Donors can be used for electron doping. For example, if vanadium replaces Ti in MnTiO₃ it is a donor. If cation or anion is replaced by an element which donates holes to the compound (more precisely, to the valence band), it is called an acceptor. Acceptors can be used for hole doping. For example, if Cr replaces Mn in MnTiO₃ it is an acceptor. An impurity atom is called isoelectronic when it comes from the same column of the periodic table as the atom it replaces. For example, if Zr replaces Ti in MnTiO₃, it is an isoelectronic impurity. Thus, dopants can be used for electron and/or hole doping.

As explained above, in order to display superconductive properties below a certain transition temperature, the material according to the present invention, having ilmenite type crystal structure shall first be modified. This can be achieved by doping, i.e. by introducing controlled defects to the material, which changes its stoichiometry or the stress in its layers. Such defects can be e.g. hydrogen, lithium, sodium or other atoms belonging to group 1 of Periodic Table of Elements, inserted to crystal structure of the material. Defects may also comprise other atomic or molecular substances, such as OH⁻.

Changing the material properties so as to achieve the superconducting properties by introducing controlled defects is well known practise in the art, YBa₂Cu₃O_{7-δ} (YBCO) being a well-known example. However, introducing such defects to ilmenite type crystal structure so as to make the material superconducting is not previously known in the art and superconductors having ilmenite type crystal structure are unknown. It is a surprising discovery of the inventors that certain defects, examples of which being presented above, introduced to a material having ilmenite type crystal structure enables said material to display superconductive properties. As an additional advantage, a material having ilmenite type crystal structure and modified by introducing certain controlled defects also acts as a HTSC.

Changing the stoichiometry of the material can also be performed, for example, through an annealing process in reducting gas atmosphere or in vacuum or in a sealed quartz tube with an oxygen getter, such as metal Ti or Ta. Heat treatment reduces the oxygen content of the material, which changes the composition of the material turning it to a superconductor. Heat treatment can also be used to increase the oxygen content, which can be done by annealing the sample under oxygen gas flow. The accurate details of the modification process vary according to the material at issue.

The present invention is based on the surprising discovery by the inventors that said ilmenite type crystal structure enables producing superconductors with a clearly simpler composition and manufacturing processes in comparison with the prior art solutions. Simplicity of the composition and manufacturing is particularly beneficial through easier control of the transition temperature below which the useful physical properties - zero or nearly zero electrical resistance and diamagnetism - appear. In addition, the superconductors according to the present invention can consist of non-toxic and relatively cheap materials only, opening for superconductors a very large variation of new practical applications. As a further, very advantageous feature, the present invention makes it possible to have materials which show simultaneous high temperature superconducting and ferromagnetic properties.

In one embodiment of the present invention X comprises at least one of the one of the following: N, P, As, O, S, F, Cl, Br, I, Se, Te, OH⁻, CN⁻, LiO⁻, and NO₂⁻. The above-mentioned non-metal elements of groups 15 to 17 of the Periodic Table of the Elements typically occupy the anion sites because they form negatively charged anions. This is also the case with the negatively charged molecules OH⁻, CN⁻, LiO⁻, and NO₂⁻, which typically occupy the anion sites because they also form negatively charged anions. In contrast, metals or transition metals form positively charged cations. Besides, the ionic radii of these non-metals elements are large which in turn further favors the anion sites.

In one embodiment of the present invention the element and/or a negatively charged molecule dominantly occupying the anion sites is at least partially replaced with at least one other element and/or another negatively charged molecule. In other words, the element and/or the molecule dominantly occupying the anion sites can be partially or fully replaced by some other element(s) and/or molecule(s) than the one that presently occupies the anion cites. The exact molar ratio between elements and/or molecules may vary.

In one embodiment of the present invention the at least one other element comprises N, P, As, O, S, F, Cl, Br, I, Se, Te; and the another negatively charged molecule comprises OH⁻, CN⁻, LiO⁻, and NO₂⁻. According to the present invention, in the case where X is dominantly occupied by oxygen, at least a part of the oxygen anions or all oxygen anions can be replaced by at least one other element than oxygen, such as N, P, As, S, F, Cl, Br, I, Se, Te, and/or by a negatively charged molecule such as OH⁻, CN⁻, LiO⁻, and NO₂⁻. If X is dominantly occupied by fluorine F, at least a part of the fluorine anions or all the fluorine anions can be replaced by at least one other element than fluorine, such as N, P, As, O, S, Cl, Br, I, Se, Te, and/or by a negatively charged molecule such as OH⁻, CN⁻, LiO⁻, and NO₂⁻.

According to the present invention X is oxygen. In yet another preferred embodiment of the present invention X comprises both oxygen and fluorine; the exact molar element ratio may vary.

Examples of possible elements forming a layer material according to the above conditions can be found e.g. among the groups 1 to 14 of the Periodic Table of the Elements. According to the present invention, the superconductor comprises material being manganese-titanium oxide MnTiO₃, where O₃ means the basic level of the oxygen content including, however, variations of it around the stoichiometric value. According to the present invention the superconductor material is electron or hole doped in order for the material to display superconductive properties above the temperature of 60 K.

In yet another embodiment of the present invention the superconductor material is hydrogen and/or Li doped in order for the material to display superconductive properties above the temperature of 60 K. Here, the material being doped with hydrogen and/or Li atoms means that said atoms are inserted in a structure of the material and they either substitute cation or anions sites, or adopt other position in the crystal structure of the material. In yet another preferred embodiment of the present invention, the superconductor comprises material which is hydrogen and/or Li doped manganese-titanium oxide MnTiO₃. As is explained in more detail below, samples of this basic composition have shown superconducting properties with a transition temperature of 68 K, or higher. Samples of this material have also shown simultaneous ferromagnetic properties, which has not been possible with the prior art superconductors.

In general, superconductors according to the present invention can be manufactured by any techniques known in the field, the different variations thereof being well known for those skilled in the art. Thus, no more detailed explanation about the manufacturing processes is needed here.

The features of the embodiments described above can be present in a material according to the present invention in any combination.

According to the use aspect of the present invention, any of the materials in accordance with the claims 1-4 is used in a superconductor. All the preferred embodiments of the present invention described above apply also to the use aspect of the invention.

### BRIEF DESCRIPTION OF THE FIGURES

In the following, one preferred embodiment of the present invention is explained in more detail with reference to the accompanying figures showing measurement results for hydrogen doped MnTiO₃ samples, wherein
Figure 1 is a characteristic graph showing the temperature dependence of the magnetic susceptibility of a zero field cooled and a field cooled sample;
Figure 2 is a characteristic graph showing the X-ray powder diffraction pattern of a sample at room temperature; and
Figure 3 is a characteristic graph showing the magnetization dependence of the applied magnetic field at different temperatures.

### DETAILED DESCRIPTION OF THE INVENTION

As an embodiment of the present invention, samples of hydrogen doped manganese-titanium oxide were prepared by first mixing a stoichiometric amount of MnO and TiO₂ powder in a 1:1 molar ratio in an agate mortar. After that the mixed powder was pressed into a pellet. Next, the pellet was preheated at 1000°C for 6 hours in a box furnace. The preheated pellet was annealed in a tube furnace after which the pellet was ground and the powder was mixed with Ti metal powder and annealed at 1000°C for 12 hours in 10% H₂, 90%Ar atmosphere. As a result, the oxygen content in the material was reduced, hydrogen was inserted into the structure and superconductor material with a transition temperature of 68 K or more was obtained.

As another embodiment of the present invention, samples of hydrogen doped manganese-titanium oxide were prepared by similarly mixing a stoichiometric amount of MnO and TiO₂ powder in a 1:1 molar ratio in an agate mortar after which the mixed powder was pressed into a pellet. Next, the pellet was preheated at 1000°C for 6 hours in a box furnace. After that, the pellet was annealed in a tube furnace at 1000°C for 12 hours in 10% H₂, 90%Ar atmosphere. As a result, the oxygen content in the material was reduced, hydrogen was inserted into the structure and superconductor material with a transition temperature of 82 K or more was obtained.

As an embodiment of the present invention, samples of Li-doped manganese-titanium oxide were prepared by similarly mixing a stoichiometric amount of MnO and TiO₂ powder in a 1:1 molar ratio in an agate mortar after which the mixed powder was pressed into a pellet. The pellet was further soaked into 0.1 mol/l LiOH aqueous solution before drying it in a tube furnace at 300°C for an hour. Alternatively, instead of soaking the pellet in a LiOH aqueous solution, the preheated powder was mixed with Li₂CO₃ powder and following that annealed in a vacuum furnace.

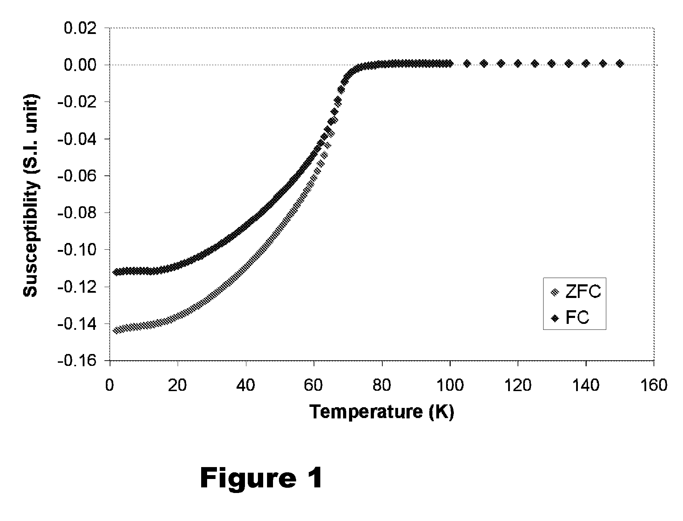

In Figure 1 is shown the dependence of the magnetic susceptibility on the temperature of the hydrogen doped MnTiO₃ sample with reduced oxygen content measured under cooling in a magnetic field (FC) and measured after cooling in a zero magnetic field (ZFC) As illustrated in Fig.1, the magnetic susceptibility begins to decrease at *T_{c}* = 68 K. Below *T_{c}* the magnetic susceptibility is negative and the material becomes diamagnetic, which is a strong evidence of superconductivity. A constant magnetic field of 79.6 A/m (1 Oersted) was applied in this measurement.

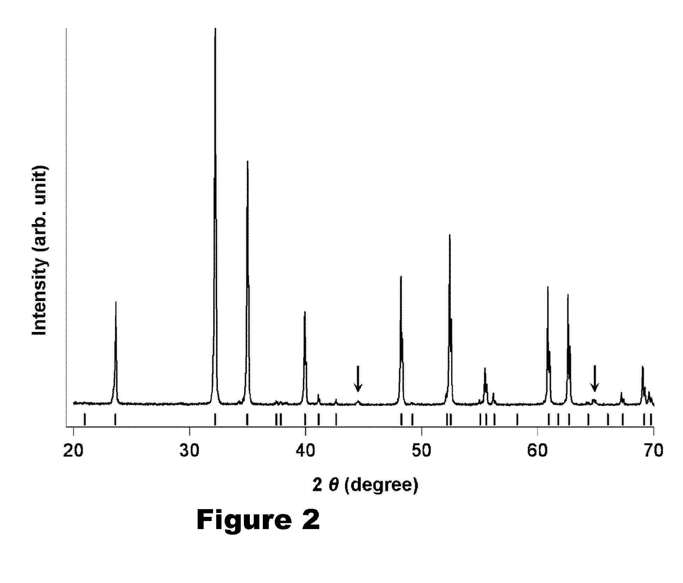

In Figure 2 is shown the X-ray powder diffraction pattern of the studied sample at room temperature. Said pattern was obtained for identification of the sample, the basic composition of which was identified as MnTiO₃. In Figure 2 tick marks correspond to the Bragg reflections from the ilmenite phase and arrows indicate the reflection from the sample holder.

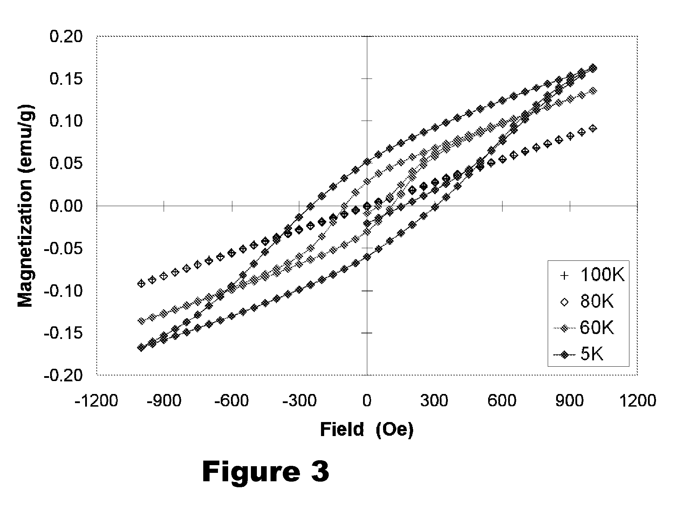

In Figure 3 is shown the dependence of the magnetization on the applied magnetic field. The measurements were taken at four different temperatures above and below *T_{c}* = 68 K; at *T* = 100 K, *T* = 80 K, *T =* 60 K and *T =* 5 K. The hysteresis loops, observed on the measurement data taken below *T_{c}* = 68 K, confirm that the studied sample, hydrogen doped MnTiO₃, is ferromagnetic.

Table 2 below shows how variations in the heat treatment details affect the superconducting properties of hydrogen doped MnTiO₃. The results illustrate the useful possibility to controllably adjust the accurate superconducting properties of the material by proper selection of the process parameters. The difference between the preparation routes of samples 1 and 2 is that an excess of Ti was added to the starting materials of sample 1 prior to heat treatments.

**Table 2.**

| Samples | Annealing time | Annealing temperature | Atmosphere | T_{c} | Mn:Ti at.% ratio |
|---|---|---|---|---|---|
| 1 | 12 hours | 1000°C | 10% H₂ 90% Ar | 68K | 1:1 |
| 2 | 12 hours | 1000°C | 10% H₂ 90% Ar | 82K | 1:0.74 |
| 3 | 6 hours | 1000°C | 10% H₂ 90% Ar | 80K | -- |

It is important to note that, as is clear for a person skilled in the art, the invention is not limited to the examples described above. The actual embodiments of the present invention can freely vary within the scope of the claims.

## Claims

1. Superconductor material comprising stacked first and second layers, each of the layers comprising a network of cations surrounded by anions,
**characterized in that**
- the material has an ilmenite crystal structure; and
- the material has a general composition of type ABX₃, where A and B are elements dominantly occupying the cation sites of the first and the second layers, correspondingly, at least one of the elements A and B being a transition metal, and X is an anion element and/or a negatively charged molecule dominantly occupying the anion sites,
- wherein the material is manganese-titanium oxide MnTiO₃, and
- the material is electron or hole doped.

2. Superconductor according to claim 1,
**characterized in that** the composition weighted average of the cations' ionic radius is below 1 Å.

3. Superconductor according to claims 1 to 2,
**characterized in that** X comprises at least one of the following: N, P, As, O, S, F, Cl, Br, I, Se, Te, OH⁻, CN⁻, LiO⁻, and NO₂⁻.

4. Superconductor according to any of claims 1 to 3,
**characterized in that** the material is hydrogen and/or Li doped.

5. Use of material comprising stacked first and second layers, each of the layers comprising a network of cations surrounded by anions, in a superconductor,
**characterized in that**
- the material has an ilmenite crystal structure; and
- the material has a general composition of type ABX₃, where A and B are elements dominantly occupying the cation sites of the first and the second layers, correspondingly, at least one of the elements A and B being a transition metal, and X is an anion element dominantly occupying the anion sites,
- wherein the material is manganese-titanium oxide MnTiO₃, and
- the material is electron or hole doped.

6. Use according to claim 5, **characterized in that** the composition weighted average of the cations' ionic radius is below 1 Å.

7. Use according to claims 5 and 6, **characterized in that** X comprises at least one of the following: N, P, As, O, S, F, Cl, Br, I, Se, Te, OH⁻, CN⁻, LiO⁻, and NO₂⁻.

8. Use according to any of claims 5 to 7, **characterized in that** the material is hydrogen and/or Li doped.

## Patentansprüche

1. Supraleitermaterial, umfassend gestapelte erste und zweite Schichten, jede der Schichten aufweisend ein Netzwerk von Kationen umringt von Anionen, **dadurch gekennzeichnet, dass**
- Das Material eine Ilmenit-Kristallstruktur aufweist; und
- Das Material eine allgemeine Zusammensetzung Typ ABX₃ aufweist, wobei A und B Elemente sind, die vorwiegend die Kationenstellen der ersten und zweiten Schichten einnehmen, entsprechend, zumindest eines der Elemente A und B ein Übergangsmetall ist, und X ein Anion-Element und / oder ein negativ geladenes Molekül ist, das vorwiegend Anionenstellen einnimmt,
- wobei das Material Mangan-Titanoxid MnTiO₃ ist, und
- das Material Elektronen-Loch-dotiert ist.

2. Supraleiter nach Anspruch 1, **dadurch gekennzeichnet, dass** der Zusammensetzungs-gewichtete Mittelwert des Kationen Ionenradius weniger als 1 Å ist.

3. Supraleiter nach den Ansprüchen 1 bis 2, **dadurch gekennzeichnet**, X mindestens eines der Folgenden umfasst: N, P, As, O, S, F, CI, Br, I, Se, Te, OH⁻, CN⁻, LiLo⁻ und NO₂⁻.

4. Supraleiter nach einem der Ansprüche 1 bis 3, **dadurch gekennzeichnet, dass** das Material Wasserstoff und / oder Li dotiert ist.

5. Verwendung eines Materials, umfassend gestapelte erste und zweite Schichten, jede der Schichten aufweisend ein Netzwerk von Kationen umringt von Anionen, in einem Supraleiter, **dadurch gekennzeichnet, dass**
- Das Material eine Ilmenit-Kristallstruktur aufweist; und
- Das Material eine allgemeine Zusammensetzung Typ ABX₃ aufweist, wobei A und B Elemente sind, die vorwiegend die Kationenstellen der ersten und zweiten Schichten einnehmen, entsprechend, zumindest eines der Elemente A und B ein Übergangsmetall ist, und X ein Anion-Element und / oder ein negativ geladenes Molekül ist, das vorwiegend Anionenstellen einnimmt,
- wobei das Material Mangan-Titanoxid MnTiO₃ ist, und
- das Material Elektronen-Loch-dotiert ist.

6. Verwendung nach Anspruch 5, **dadurch gekennzeichnet, dass** der Zusammensetzungs-gewichtete Mittelwert des Kationen Ionenradius weniger als 1 Å ist.

7. Verwendung nach den Ansprüchen 5 und 6, **dadurch gekennzeichnet**, X mindestens eines der Folgenden umfasst: N, P, As, O, S, F, CI, Br, I, Se, Te, OH⁻, CN⁻, LiLo⁻ und NO₂⁻.

8. Verwendung nach einem der Ansprüche 5 bis 7, **dadurch gekennzeichnet, dass** das Material Wasserstoff und / oder Li dotiert ist.

## Revendications

1. Matériau supraconducteur comprenant une première et une seconde couche, empilées l'une sur l'autre, chaque couche comprenant un réseau de cations entourés d'anions, **caractérisé en ce que**
- le matériau présente une structure cristalline d'ilménite, et
- le matériau présente une composition générale de type ABX₃, dans laquelle A et B sont des éléments occupant, de manière dominante, les sites cationiques de la première et de la seconde couche, par conséquent, au moins un des éléments A et B est un métal de transition, et X est un élément anionique et/ou une molécule chargée négativement occupant les sites anioniques de manière dominante,
- le matériau étant un de titanate de manganèse MnTiO₃, et
- le matériau est dopé avec des électrons ou des trous.

2. Supraconducteur suivant la revendication 1, **caractérisé en ce que** le rayon ionique moyen pondéré des cations de la composition est inférieur à 1 A.

3. Supraconducteur suivant les revendications 1 à 2, **caractérisé en ce que** X comprend au moins un parmi les éléments et composés suivants : N, P, As, O, S, F, Cl, Br, I, Se, Te, OH, EN, LiO⁻ et NO₂⁻.

4. Supraconducteur suivant une des revendications 1 à 3, **caractérisé en ce que** le matériau est de l'hydrogène dopé et/ou du Li dopé.

5. Utilisation, dans un supraconducteur, d'un matériau comprenant une première et une seconde couche, empilées l'une sur l'autre, chaque couche comprenant un réseau de cations entourés d'anions, **caractérisée en ce que**
- le matériau présente une structure cristalline d'ilménite, et
- le matériau présente une composition générale de type ABX3, dans laquelle A et B sont des éléments occupant, de manière dominante, les sites cationiques de la première et de la seconde couche, par conséquent, au moins un des éléments A et B est un métal de transition et X est un élément anionique et ou une molécule chargée négativement occupant les sites anioniques de manière dominante,
- le matériau étant un titanate de manganèse MnTiO₃, et
- le matériau est dopé avec des électrons ou des trous.

6. Utilisation suivant la revendication 5, **caractérisée en ce que** le rayon ionique moyen pondéré des cations de la composition est inférieur à 1 A.

7. Utilisation suivant les revendications 5 et 6, **caractérisée en ce que** X comprend au moins un parmi les éléments et composés suivants : N, P, As, O, S, F, Cl, Br, I, Se, Te, OH, EN, LiO⁻ et NO₂⁻.

8. Utilisation suivant une quelconque des revendications 5 à 7, **caractérisée en ce que** le matériau est dopé à l'hydrogène et/ou au lithium.
